# EUROPEAN PATENT SPECIFICATION

(11) **EP 1 872 287 B1**
(45) Date of publication and mention of the grant of the patent: **08.11.2017**
(21) Application number: 06748662.1
(22) Date of filing: 24.03.2006
(51) Int. Cl.: G06F 17/50

(54) **CUSTOMIZED PROCESSING IN ASSOCIATION WITH FINITE ELEMENT ANALYSIS**
MASSGESCHNEIDERTE INFORMATIONSVERARBEITUNG IM ZUSAMMENHANG DER FINITE-ELEMENTE-ANALYSE
TRAITEMENT PERSONNALISÉ ASSOCIÉ À UNE ANALYSE PAR ÉLÉMENTS FINIS

(30) Priority: 18.04.2005 US 109229
(43) Date of publication of application: 02.01.2008
(73) Proprietor: The Boeing Company, Chicago, IL 60606-1596 (US)
(72) Inventor: CHI, Allen, W., Bellevue, Washington 98006 (US)
(74) Representative: Howson, Richard G.B.
(86) International application number: PCT/US2006/010808
(87) International publication number: WO 2006/113045

(56) References cited:
- COMPUTATIONAL ENGINEERING INTERNATIONAL: "ENSIGHT 7.6 HOWTO MANUAL (selected sections)" 2003, CEI , XP002391267 Sections: EnSight Overview, Read Data, Read EnSight 5 Data, Load Multiple Datasets (Cases), Create Material Parts, and Set or Modify Preferences. * Ensight Overview: page 1, paragraph 1; page 2, paragraph 5-8 * * Read Data: page 1, paragraph 2, 3 * * Read EnSight 5 Data: page 1, paragraph 1, 4; steps 1-6 * * Load Multiple Datsets (Cases): page 1, paragraph 1, 2 * * Create Material Parts: page 1, paragraph 3 * * Set or Modify Preferences: the entire section *
- HERBERT DE GERSEM ET AL: "Object-Oriented Implementation of an Interactive and Automatic Field-Processing Surface" IEEE TRANSACTIONS ON MAGNETICS, IEEE SERVICE CENTER, NEW YORK, NY, US, vol. 36, no. 4, July 2000 (2000-07), XP011032598 ISSN: 0018-9464
- KARPURAPU R ET AL: "DEVELOPMENT OF A FINITE ELEMENT ANALYSIS POST-PROCESSING PROGRAM" ADVANCES IN ENGINEERING SOFTWARE, ELSEVIER SCIENCE, OXFORD, GB, vol. 16, no. 1, 1993, pages 15-22, XP000922569 ISSN: 0965-9978

## Description

### BACKGROUND

Finite-element models are an important tool in the design and verification of many engineered structures and systems. For example, finite element models may define a working environment in terms of forces, accelerations, etc., and can thus be used to determine structural integrity of an engineered structure within that working environment. Through the use of finite element models, it is possible to break a complex system down into a manageable (finite) number of elements (e.g., a curve drawn as a series of steps). Finite element models may be used for several purposes. For example, finite element models may help determine the behavior of a new airplane product design under various load environments.

Because of the interdisciplinary nature of finite element models (which typically combine concepts from mathematics, physics, engineering and computer science), generating and using a finite element model typically involves multiple phases such as a pre-processing phase, a processing phase, and a post processing phase. During the pre-processing phase, a finite element analyst uses one or more computer programs to develop a finite element model. In the case of a structure, this may include creating a finite element mesh to divide the structure's geometry into subdomains for mathematical analysis and applying material properties and boundary conditions to this geometry. During the processing phase, a finite element analysis program derives and solves governing matrix equations from the model created during pre-processing. During the post processing phase, the analyst uses one or more programs to check the validity of the solutions from the processing phase (e.g., displacements, stresses, specialized stresses, error indicators, etc.) and to perform other analysis.

Most customized post processing programs are model-specific, meaning they are hard coded to fit a designated finite element model representing a known structure. Thus, a new programming effort may be need for new finite element models, and any changes to an existing model's geometry, design configuration, interface modeling, and output requirements may lead to additional programming efforts. Once configured, many of these post processing programs are in a rigid format and are difficult to expand or change. As a result, numerous sets of post processing programs may be required when multiple structures or structure variations are being modeled. For example, each time a new finite model is to be analyzed, a programmer may need to write and compile a new post processing program (e.g., in a programming language such as FORTRAN, Java, C++, etc.) for that specific finite element model.

The publication " Computational Engineering International: Ensight 7.6 How To Manual", 2003, CEI, XP002391267 provides an overview of the Ensight post processing software package.

### SUMMARY

A computerized facility providing a flexible scheme for analysis of finite element models is disclosed. In some embodiments, the facility allows the user to create a set of control files to define a customized processing routine that can be applied to a specific finite element model, without having to write or rewrite any programming code. For example, a non-programmer can use an interface provided by the facility to configure various aspects of a post processing routine (instead of having to write and compile a new program using a programming language such as Fortran, Java, C, C++, C#, J#, etc.). Via this interface, the user may provide model-specific attribute information that can then be applied to a flexible post processing scheme to produce a customized post processing result. The facility may be implemented using object-oriented concepts and/or other programming concepts.

In some embodiments, the facility may include a finite element post processing framework, wherein the finite element post processing framework is not specific to a particular finite element model. Customizing the post processing framework may include configuring a control file to control one or more processes associated with the post processing framework. The finite element post processing framework may be based, at least in part on one or more data structures, including, for example, a database element, an interface element including a collection of degrees of freedom connecting two or more structural components, a freebody element for collecting interfaces and assembling load balance tables of components, a summary element for processing and sorting a selection of interfaces and generating a summary table, a utility functions element, a post element instantiated according to an overall process flow and scope of post processing, a graphical user interface element, etc.

The facility may also include an interface component configured to receive input from an end user, wherein the interface component receives input associated with customizing the post processing framework so that it can be applied to a specific finite element model. In some embodiments, the end user does not perform hard coding when providing input to the interface. The input from the end user may include interface information specific to the finite element model, local coordinate information specific to the finite element model, component information specific to the finite element model, summary table preferences for use in generating a summary table resulting from the post processing, etc.

In some embodiments, processing and/or post processing is performed on a specific finite element model by a method comprising receiving input for use in generating one or more control instructions (e.g., control files) to define a customized processing routine that can be applied to a specific finite element model, wherein receiving the input does not include a user writing or rewriting programming code, and generating the one or more control instructions based on the received input, including applying the received input to a generic processing framework, wherein generating the control instructions does not include a user writing or rewriting programming code.

According to an aspect there is provided a system for performing analysis on finite element models as defined in claim 1. According to another aspect there is provided a method for conducting processing of a finite element model as defined in claim 9.

### BRIEF DESCRIPTION OF THE DRAWINGS

Figure 1 is a block diagram showing an example of a representative environment in which the finite element model post processing scheme may be implemented.
Figure 2 is a block diagram showing an object-oriented implementation of the finite element model post processing scheme.
Figure 3 is a data diagram showing various sample data structures associated with an example implementation of the finite element post processing scheme.
Figure 4 is a data diagram showing various classes associated with an example implementation of the finite element post processing scheme.
Figure 5 is a flow diagram showing an overview of a routine for configuring a post processing control file.
Figure 6 is a flow diagram showing a routine for defining an interface for configuration of a post processing control file.
Figure 7 is a flow diagram showing a routine for defining a local coordination system for configuration of a post processing control file.
Figure 8 is a flow diagram showing a routine for defining a component for configuration of a post processing control file.
Figure 9 is a flow diagram showing a routine for defining a summary table for configuration of a post processing control file.

### DETAILED DESCRIPTION

### 1. Representative Environment

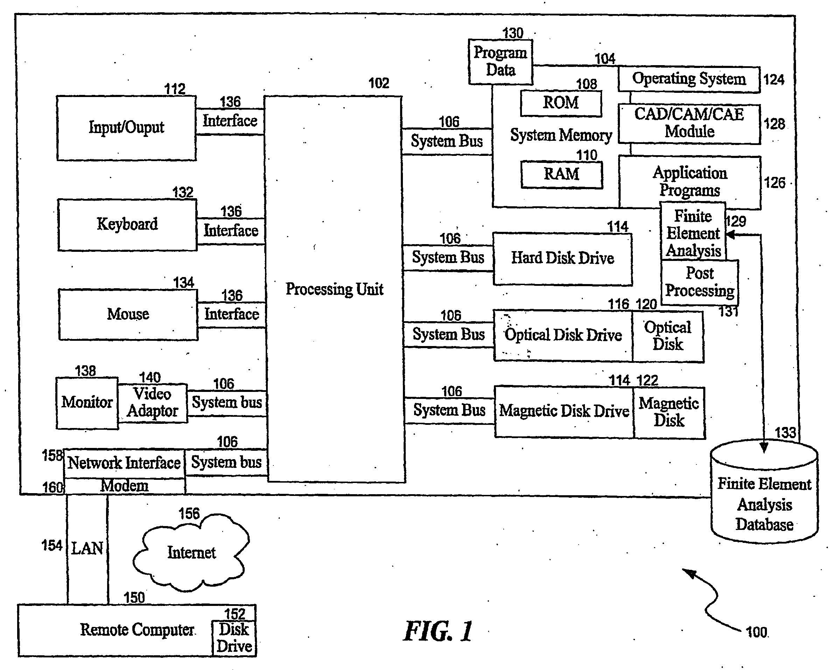

Figure 1 and the following discussion provide a brief, general description of a suitable computing environment in which the post processing facility can be implemented. Although not required, embodiments of the post processing facility will be described in the general context of computer-executable instructions, such as routines executed by a general purpose computer, e.g., a server or personal computer. Those skilled in the relevant art will appreciate that the post processing facility can be practiced with other computer system configurations, including Internet appliances, hand-held devices, wearable computers, cellular or mobile phones, multi-processor systems, microprocessor-based or programmable consumer electronics, set-top boxes, network PCs, mini-computers, mainframe computers and the like. The post processing facility can be embodied in a special purpose computer or data processor that is specifically programmed, configured or constructed to perform one or more of the computer-executable instructions explained in detail below. The post processing facility can also be practiced in distributed computing environments where tasks or modules are performed by remote processing devices, which are linked through a communications network. In a distributed computing environment, program modules may be located in both local and remote memory storage devices. Indeed, the term "computer", as used generally herein, refers to any of the above devices and systems, as well as any data processor.

Aspects of the post processing facility described below may be stored or distributed on computer-readable media, including magnetic and optically readable and removable computer disks, as well as distributed electronically over the Internet or over other networks (including wireless networks). Those skilled in the relevant art will recognize that portions of the post processing facility reside on a server computer, while corresponding portions reside on a client computer. Data structures and transmission of data particular to aspects of the post processing facility are also encompassed within the scope of the post processing facility.

Referring to Figure 1, a conventional personal computer 100 includes a processing unit 102, a system memory 104, and a system bus 106 that couples various system components including the system memory to the processing unit 102. The processing unit 102 may be any logic processing unit, such as one or more central processing units (CPUs), digital signal processors (DSPs), application-specific integrated circuits (ASIC), etc. Unless described otherwise, the construction and operation of the various blocks shown in Figure 1 may be of conventional design. As a result, such blocks need not be described in further detail herein, as they will be readily understood by those skilled in the relevant art.

The system bus 106 can employ any known bus structures or architectures, including a memory bus with memory controller, a peripheral bus, and a local bus. The system memory 104 may include read-only memory ("ROM") 108 and random access memory ("RAM") 110. A basic input/output system ("BIOS") 112, which can form part of the ROM 108, contains basic routines that help transfer information between elements within the personal computer 100, such as during start-up.

The personal computer 100 also includes a hard disk drive 114 for reading from and writing to a hard disk (not shown), and an optical disk drive 116 and a magnetic disk drive 118 for reading from and writing to removable optical disks 120 and magnetic disks 122, respectively. The optical disk 120 can be a CD-ROM, while the magnetic disk 122 can be a magnetic floppy disk. The hard disk drive 114, optical disk drive 116, and magnetic disk drive 118 may communicate with the processing unit 102 via the bus 106. The hard disk drive 114, optical disk drive 116, and magnetic disk drive 118 may include interfaces or controllers (not shown) coupled between such drives and the bus 106, as is known by those skilled in the art. The drives 114, 116, and 118, and their associated computer-readable media, provide nonvolatile storage of computer readable instructions, data structures, program modules, and other data for the personal computer 100. Although the depicted personal computer 100 may employ a hard disk, optical disk 120, and magnetic disk 122, those skilled in the relevant art will appreciate that other types of computer-readable media that can store data accessible by a computer may be employed, such as magnetic cassettes, flash memory cards, digital video disks ("DVD"), Bernoulli cartridges, RAMs, ROMs, smart cards, etc.

Program modules can be stored in the system memory 104, such as an operating system 124, one or more application programs 126, other programs or modules 128, and program data 130. The application programs 126 include finite element analysis facilities or applications 129, including a post processing facility 131. While shown in Figure 1 as being stored in the system memory 104, the operating system 124, application programs 126, other modules 128, and program data 130 can be stored on the hard disk of the hard disk drive 114, the optical disk 120 of the optical disk drive 116, and/or the magnetic disk 122 of the magnetic disk drive 118. A database 133 that stores information for finite element models and analysis may also be present (either external or internal to the personal computer 100).

A user can enter commands and information into the personal computer 100 through input devices such as a keyboard 132 and a pointing device such as a mouse 134. Other input devices (not shown) can include a microphone, joystick, game pad, scanner, etc. These and other input devices are connected to the processing unit 102 through an interface 136 (e.g., a serial port interface, a parallel port, game port, universal serial bus ("USB") etc.) that couples to the bus 106. A monitor 138 or other display device may be coupled to the bus 106 via a video interface 140, such as a video adapter. The personal computer 100 can include other output devices, such as speakers, printers, etc.

The personal computer 100 can operate in a networked environment using logical connections to one or more remote computers, such as a remote computer 150. The remote computer 150 can be another personal computer, a server, a router, a database, a network PC, a peer device or other common network node, and typically includes many or all of the elements described above for the personal computer 100. Typically, the remote computer 150 includes a memory storage device such as a disk drive 152 shown in Figure 1. The remote computer 150 is logically connected to the personal computer 100 under any known method of permitting computers to communicate, such as through a local area network ("LAN") 154 or a wide area network ("WAN") or Internet 156. Such networking environments are well known in offices, enterprise-wide computer networks, intranets and the Internet.

In a LAN networking environment, the personal computer 100 is connected to the LAN 154 through an adapter or network interface 158 (coupled to the bus 106). When used in a WAN networking environment, the personal computer 100 often includes a modem 160 or other device for establishing communications over the WAN/Internet 156. The modem 160 is shown in Figure 1 as coupled between the interface 136 and the WAN/Internet 156. In a networked environment, program modules, application programs, or data, or portions thereof, can be stored in the remote computer 150, such as in the disk drive 152. Those skilled in the relevant art will readily recognize that the network connections shown in Figure 1 are only some examples of establishing communication links between computers, and other links may be used, including wireless links. In general, while hardware platforms, such as the personal computer 100 and remote computer 150, are described herein, aspects of the post processing facility are equally applicable to nodes on a network having corresponding resource locators to identify such nodes.

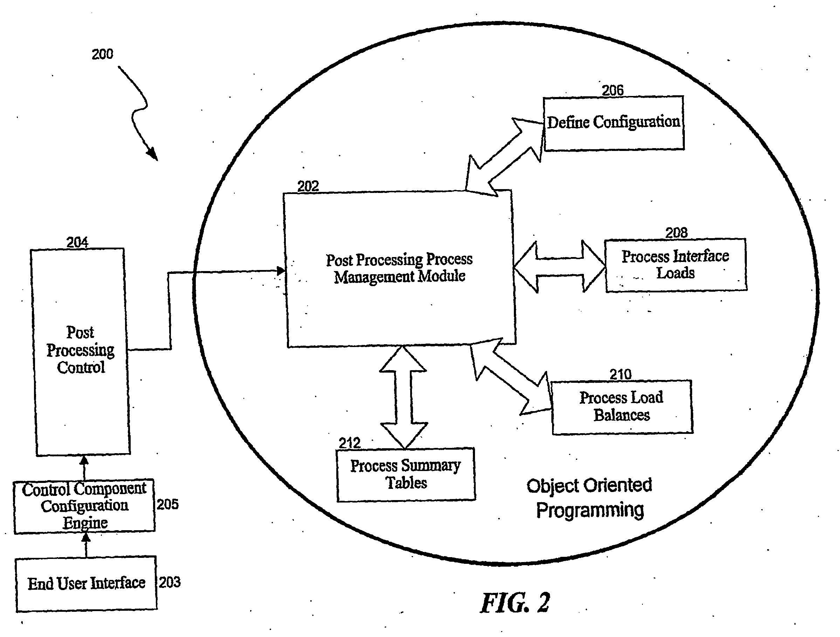

Figure 2 is a block diagram showing an example of actions performed by a post processing facility 200. In some embodiments, a post processing process management module 202 performs various tasks associated with post processing of a finite element model. To allow for customization, the post processing process management module 202 may be controlled, at least in part, by a post processing control component 204. The post processing control component may be based, at least in part, on information provided by an end user via an end user interface 203, which is then configured using a control component configuration engine 205.

Tasks performed by the post processing process management module 202 (under the at least partial control of the control component 204) may include a define configuration task 206, a process interface loads task 208, a process load balances task 210, and a process summary tables task 212. As illustrated, many of the tasks associated with the process management module 202 may be performed, for example, in the context of object oriented programming. For example, attribute information provided by the post processing control component 204 may be introduced into an object oriented environment to instantiate various objects used in performing the tasks (206, 208, 210, and 212).

An example of an engine freebody output resulting from performing post processing on a finite element model relating to aircraft design is shown in the following table:

**Table A**

| **Output Example - Load Balance Table** | | | | | | |
|---|---|---|---|---|---|---|
| 0++++ REACTIONS +++++ | Force X | Force Y | Force Z | Moment X | Moment Y | Moment Z |
| A-FLANGE | 2965 | -732 | 2816 | 0 | -237 | -61 |
| INNER V-GROOVE | 4912 | -5006 | 2583 | 0 | -162 | -358 |
| OUTER V-GROOVE | -44860 | -6323 | 10575 | 0 | 545 | -1495 |
| CORE COWL BUMPERS | 0 | -4500 | -12306 | 0 | 2637 | -964 |
| V-BAND TERMINALS | | | | | | |
| STA 193.20 BL-10.55 | 4 | 141 | -945 | 1 | 88 | 13 |
| STA 193.20 BL 10.55 | -1 | -142 | -944 | -1 | 88 | -13 |
| TOTAL V-BAND TERMINALS | 3 | 0 | -1889 | 0 | 176 | 0 |
| FWD ENGINE MOUNT LINKS | | | | | | |
| Q1 - WL 167.919 BL -7.814 | 1 | 7835 | -13573 | -426 | 1176 | 679 |
| Q2 - WL 167.919 BL 7.814 | 1 | -15668 | -27140 | 852 | 2352 | -1358 |
| C1 - WL 168.367 BL 0.000 | 0 | 0 | 0 | 0 | 0 | 0 |
| - TOTAL FWD ENGINE MOUNT LINKS - | 2 | -7832 | -40713 | 426 | 3528 | -679 |
| AFT ENGINE MOUNT LINKS | | | | | | |
| Q5 - WL 132.291 BL -15.55 | 6 | 39000 | 18789 | -1552 | -3942 | 8183 |
| Q6 - WL 132.291 BL 15.55 | 7 | -17703 | 35803 | 1128 | -7512 | -3715 |
| C2 - WL 135.881 BL 0.00 | 0 | 0 | 0 | 0 | 0 | 0 |
| - TOTAL AFT ENGINE MOUNT LINKS - | 13 | 21297 | 54592 | -423 | -11454 | 4468 |
| THRUST LINKS | | | | | | |
| WL 115.591 BL-15.55 | 72525 | 6931 | 19698 | -472 | -809 | 2023 |
| WL 115.591 BL 15.55 | 72525 | -6903 | 19698 | 472 | -809 | -2021 |
| - TOTAL THRUST LINKS - | 145049 | 28 | 39395 | 0 | -1619 | 3 |
| | | | | | | |
| +++ APPLIED LOADS +++ | -108085 | 3068 | -55055 | -2 | 6587 | -914 |

### 2. Data structure

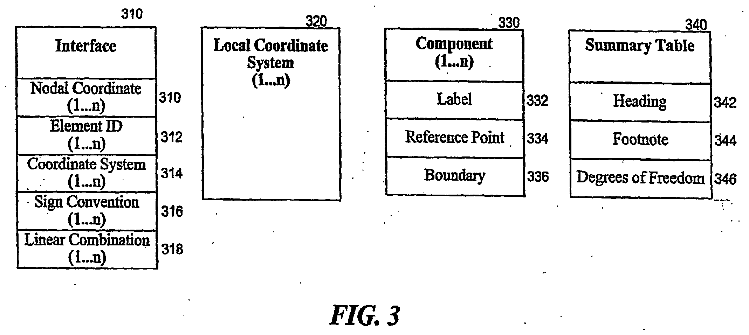

Figure 3 is a data diagram showing various data structures used in collecting information from an end user (e.g., an end user who is familiar with finite element models, but who need not exercise programming skills). In turn, this information may be used to configure a post processing control file. In some embodiments, the various data structures may include an interface data structure 310, a local coordination system data structure 320, a component data structure 330, and a summary table data structure 340, although other data structures or combinations of data structures are possible in the context of receiving input from an end user.

The interface data structure 310 may include various types of interface-related information specific to a particular finite element model that is to be the subject of post processing. In some embodiments, this information may include nodal coordinate information 310, element ID information 312, coordinate system information 314, sign convention information 316, and linear combination information 318. In some cases, this information is provided by an end user. An example of the contents of the interface data structure 310 is illustrated in the following table:

**Table B**

| EIDTX | EIDTY | EIDTZ | X | Y | Z | SIGN | CS | Label |
|---|---|---|---|---|---|---|---|---|
| 131241 | 131242 | 131243 | 309.819 | -15.55 | 132.291 | ------ | R009 | Q5 |
| 131238 | 131239 | 131240 | 309.819 | 15.55 | 132.291 | ------ | R010 | Q6 |
| 131281 | 131282 | 131283 | 309.819 | 0 | 135.881 | ------ | R021 | C2 |

The local coordinate system data structure 320 may contain information for one or more coordinate systems used in defining the finite element model that is the subject of the post processing. As with the interface data structure 310, the information associated with the local coordinate system data structure 320 may be provided by an end user. An example of the contents of the local coordinate system data structure 320 is illustrated in the following table:

**Table C**

| ID | A1 | A2 | A3 | B1 | B2 | B3 | C1 | C2 | C3 |
|---|---|---|---|---|---|---|---|---|---|
| R007 | 186.65 | 9.76 | 171.30 | 186.65 | 7.81 | 167.92 | 185.60 | 9.76 | 171.30 |
| R008 | 186.65 | -9.76 | 171.30 | 186.65 | -7.81 | 167.92 | 185.60 | -9.76 | 171.30 |
| R009 | 309.82 | -12.00 | 138.96 | 309.82 | -15.55 | 132.29 | 308.82 | -12.00 | 138.96 |
| R010 | 309.82 | 11.29 | 140.91 | 309.82 | 15.55 | 132.29 | 308.82 | 11.29 | 140.91 |
| R013 | 198.50 | 18.49 | 115.59 | 298.35 | 8.96 | 142.87 | 198.41 | 19.39 | 116.25 |
| R014 | 198.50 | -18.49 | 115.59 | 298.35 | -8.96 | 142.87 | 198.41 | -19.39 | 116.25 |
| R021 | 0.00 | 0.00 | 100.00 | 100.00 | 0.00 | 100.00 | 100.00 | 50.00 | 100.00 |

The component data structure 330 may include information on various components within the finite element model subject to the post processing, as provided, for example, by an end user. For example, the component data structure 330 may include label information 332, reference point information 334, boundary information 336, and output requirements 338 for one or more components. An example of the contents of the component data structure 330 is illustrated in the following table:

**Table D**

| **Label - Engine Load Balance** | | |
|---|---|---|
| **Reference Node - NS 100, BL 0, WL 100** | | |
| **Boundary Definition** | | |
| **Interface** | **Show Member** | **Note** |
| InletToEngine | No | $ENGINE INTERFACE |
| InnerVeeGroove | No | $INNER V-GROOVE |
| OuterVeeGroove | No | $OUTER V-GROOVE |
| AftCowlBumpers | No | $CORE COWL BUMPERS |
| VBandTerminals | Yes | $V-BAND TERMINALS |
| FwdEngineMountLinks | Yes | $Fwd Mount |
| AftEngineMountLinks | Yes | $Aft Mount |
| ThrustLinks | Yes | $Thrust Link |

The summary table data structure 340 may, likewise, include heading information 342, footnote information 344, and degrees of freedom (DOF) information 346, as provided, for example, by an end user. An example of the contents of the component data structure 330 is illustrated in the following table:

**Table E**

| **Define Interfaces** | |
|---|---|
| **Type** | **Name** |
| Cylindrical | InletToEngine |
| Cylindrical | InnerVeeGroove |
| Cylindrical | OuterVeeGroove |
| Cylindrical | AftCowlBumpers |
| Cylindrical | VBandTerminals |
| Orthogonal | FwdEngineMountLinks |
| Orthogonal | AftEngineMountLinks |
| Orthogonal | ThrustLinks |
| Orthogonal | StrutToWing |
| | |

| **Define Freebody** | |
|---|---|
| | Engine |
| | Strut |

| **Define Summary** | |
|---|---|
| | EngineMount |

This collection information described above, as well as other information, may be combined to configure a post processing control file to be used in a post processing program or other post processing routine specific to the finite element model under analysis. In this way, custom information can be provided to a generic post processing scheme, such as an object oriented post processing scheme to allow a non-programming end user to customize a post processing program to fit a specific finite element model in a way that is easy to use and does not require any hard coding by an end user.

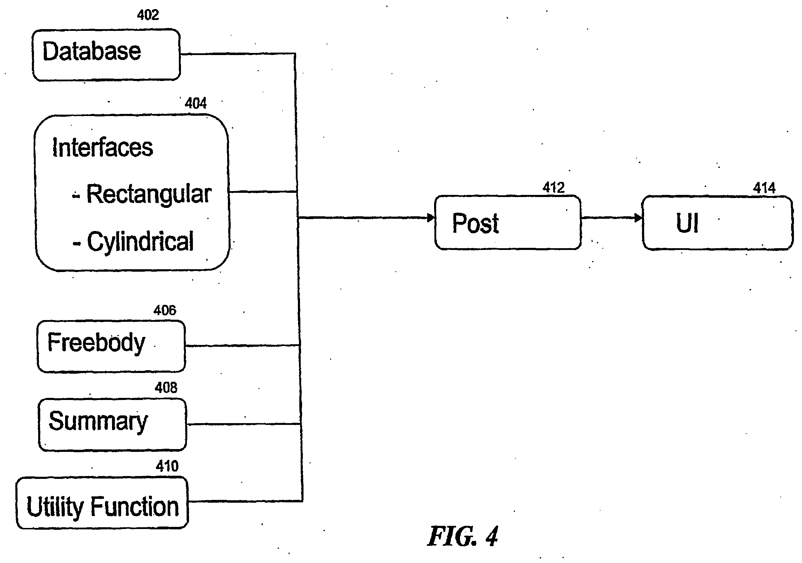

Figure 4 is a data diagram showing various classes associated with an implementation of the post processing scheme, such as an object oriented implementation. A database class 402 may be used to process and store data generated from integrated finite element analysis. An example of an object instantiated from such a class includes a design load analysis object. An interface class 404 may be associated with a collection of degree of freedoms (DOFs) connecting two structural components. Two subclasses that may inherit from the interface class 404 may include a rectangular subclass and a cylindrical subclass. These subclasses are defined individually to process two different types of interfaces. For example, a rectangular subclass interface may process interfaces defined in a rectangular coordinate system (e.g., a pylon to a wing attachment). A cylindrical subclass may be configured to process interfaces defined in cylindrical coordinate systems (e.g., any ring interfaces such as an inlet to an engine attachment).

A freebody class 406 may be used to collect multiple interfaces and assemble load balance tables of components defined within such interfaces. In addition, the freebody class 406 may include functionality to perform freebody balance checks of such components. Examples of the components include an engine, a strut, and a wing. A summary class 408 may be associated with functionality to process and sort a selection of interfaces and generate a summary table (e.g., a summary table associated with a load release document). For example, the summary class 408 functionality may be used to analyze an engine mount load summary and a wing attachment load summary.

In some embodiments, a utility function class 410 may be used to collect a group of utility functions associated with post processing. Based on the collected utility functions, a post object 412 may be instantiated according to the user input control file to control the overall process flow and scope of post processing. In addition, a graphical user interface object 414 may be instantiated to provide the end user with information associated with such post processing.

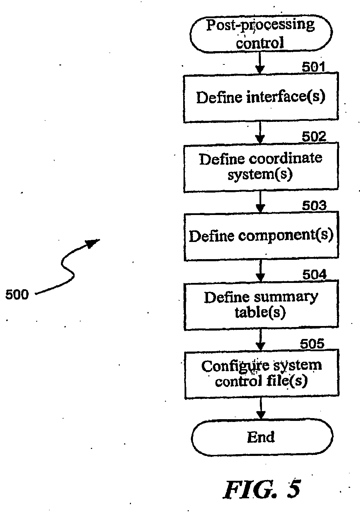

Figure 5 is a flow diagram showing a routine 500 for generating and/or configuring a post processing control file. At block 501 the routine 500 may define one or more interfaces based, for example, on end user input. At block 502 the routine 500 may define one or more coordinate systems based, for example, on end user input. At block 503 the routine 500 may define one or more components based, for example, on end user input. At block 504 the routine 500 may define one or more summary tables based, for example, on end user input. At block 505 the routine 500 may configure one or more system control files based on the information received with respect to blocks 501, 502, 503, and 504, as well as possibly other information. The routine 500 then ends.

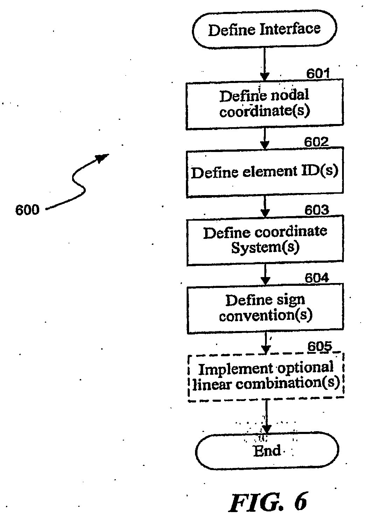

Figure 6 is a flow diagram showing an example of a routine 600 for defining an interface (e.g., such as with respect to block 501 of Figure 5). At block 601 the routine 600 may define one or more nodal coordinate systems for the post processing based, for example, on end user input. At block 602 the routine 600 may define one or more element IDs associated with each element of the finite element model subject to post processing based, for example, on end user input. At block 603 the routine 600 may define one or more coordinate systems associated with the finite element model subject to post processing based, for example, on end user input. At block 604 the routine 600 may define sign conventions for the finite element model associated with the post processing based; for example, on end user input. At optional block 605 the routine 600 implements optional linear combination definitions based, for example, on end user input. The routine 600 then ends.

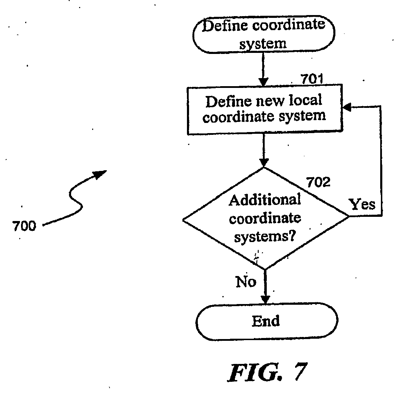

Figure 7 shows an example of a routine 700 for defining a coordinate system in conjunction with creating a control file for post processing. At block 701 the routine 700 may define a new local coordinate system based, for example, on end user input. At decision block 702 the routine 700 may check for additional coordinate system. If none are found the routine 700 ends. Otherwise the routine 700 loops back to block 701 to define a next local coordinate system.

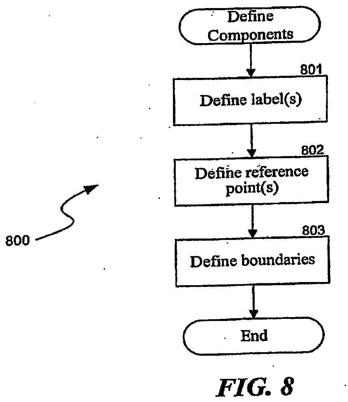

Figure 8 shows an example of a routine 800 for defining components in association with creating a control file for post processing a finite element model. At block 801 the routine 800 may define label information based, for example, on end user input. At block 802 the routine 800 may define reference point information based, for example, on end user input. At block 803 the routine 800 may define boundary information based, for example, on end user input. At block 804 the routine 800 may define output requirements based, for example, on end user input. The routine 800 then ends.

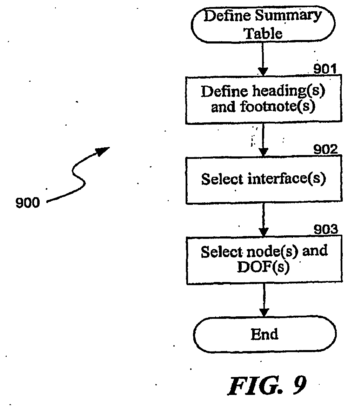

Figure 9 shows an example of a routine 900 for defining a summary table in accordance with configuring a control file for controlling a post processing routine. At block 901 the routine 900 may define heading and footnote information based, for example, on end user input. At block 902 the routine 900 may select an interface based, for example, on end user input. At block 903 the routine 900 may select node information and degrees of freedom information based, for example, on end user input. The routine 900 then ends.

## Claims

1. A system for analysing finite element models, the system comprising:
a finite element post processing framework (200), wherein the finite element post processing framework is not specific to a particular finite element model, the finite element post processing framework based at least in part on one or more data structures comprising:
an interface element (310) including a collection of degree of freedoms each connecting two structural components,
a freebody element (330) for collecting boundary interfaces and assembling load balance tables of components, and
a summary element (340) for processing and sorting a selection of interfaces and generating a summary table;
a user interface component (203) configured to receive input from an end user, wherein the user interface couples said input to a configuration engine (205) to customize the post processing framework so that it can be applied to a specific finite element model; and
a post processing component (204) configured to perform post processing on the specific finite element model based on the customized post processing framework.

2. The system of claim 1 wherein customizing the post processing framework (200) includes configuring a control file to control one or more processes associated with the post processing framework.

3. The system of claim 1 wherein the post processing framework (200) is implemented using object oriented programming (206, 208, 210, 212).

4. The system of claim 1 wherein the input from the end user includes:
interface information (310) specific to the finite element model;
local coordinate information (320) specific to the finite element model;
component information (330) specific to the finite element model; and
summary table preferences (340) for use in generating a summary table resulting from the post processing.

5. The system of claim 1 wherein the input from end users includes:
interface information specific to the finite element model, wherein the interface information includes nodal coordinate information (310), element identifier information (312), sign convention information (316), and linear combination information (318);
local coordinate information (320) specific to the finite element model;
component information (330) specific to the finite element model, wherein the component information includes label information (332), reference point information (334), and boundary information (336); and
summary table preferences (340) for use in generating a summary table resulting from the post processing, wherein the summary table information includes heading information (342), footnote information (344), and degrees of freedom information (346).

6. The system of claim 1 wherein the finite element post processing framework (200) is based, at least in part on one or more data structures comprising:
a database element (402);
a utility functions element (410);
a post element (412) instantiated according to an overall process flow and scope of post processing; and
a graphical user interface element (414).

7. The system of claim 1 wherein the end user does not perform hard coding when providing input to the interface.

8. The system of claim 1
wherein the input from the end user includes:
interface information specific to the finite element model,
local coordinate information specific to the finite element model,
component information specific to the finite element model, and
summary table preferences for use in generating a summary table resulting from the post processing; and
wherein the finite element post processing framework is based, at least in part on one or more data structures comprising:
a database element (402),
an interface element (404) including a collection of degree of freedoms each connecting two structural components,
a freebody element (406) for collecting boundary interfaces and assembling load balance tables of components,
a summary element (408) for processing and sorting a selection of interfaces and generating a summary table,
a utility functions element (410),
a post element (412) instantiated according to an overall process flow and scope of post processing, and
a graphical user interface element (414).

9. A method for conducting processing of a finite element model, the method comprising:
receiving input for use in generating one or more control instructions to define a customized processing routine that can be applied to a specific finite element model, wherein receiving the input does not include a user writing or rewriting programming code in a programming language; and
generating the one or more control instructions based on the received input, including applying the received input to a generic processing framework, wherein generating the control instructions does not include a user writing or rewriting programming code and wherein generating the one or more control instructions is executed by a post processing software facility defined, at least in part, based on one or more software programming classes including at least one of:
an interface class (404) including a collection of degree of freedoms each connecting two structural components,
a freebody class (406) for collecting boundary interfaces and assembling load balance tables of components defined based on the input from the end user, and
a summary class (408) for processing and sorting a selection of interfaces and generating a summary table.

10. The method of claim 9, further comprising performing post processing on one or more finite element models based on the one or more control instructions.

11. The method of claim 9, further comprising performing post processing on one or more finite element models based on the one or more control instructions, wherein in post processing includes:
defining a configuration (206) for the post processing based, at least in part, on the one or more control instructions;
processing interface loads (208) based, at least in part, on the one or more control instructions;
processing load balances (210) based, at least in part, on the one or more control instructions; and
processing summary tables (212) based, at least in part, on the one or more control instructions.

12. The method of claim 9 wherein the received input is collected in one or more data structures (310, 320, 330, 340) stored on a computer-readable medium, wherein each of the one or more data structures includes one or more type of information from a group comprising:
interface information specific to the finite element model;
local coordinate information specific to the finite element model;
component information specific to the finite element model; and
summary table preferences specific to the finite element model.

13. The method of claim 9 wherein the generic processing framework is an object oriented post processing framework.

14. The method of claim 9 wherein the processing framework is associated with a post processing aspect of a finite element analysis application.

15. The method of claim 9 wherein the input is received via an end user interface and includes data but not explicit relationships between data.

16. The method of claim 9 wherein generating the control instructions is performed, at least in part, by a control component engine (205).

## Patentansprüche

1. System zum Analysieren von Finite-Elemente-Modellen, wobei das System aufweist:
ein Finite-Elemente-Nachbereitungs-Framework (200), wobei das Finite-Elemente-Nachbereitungs-Framework nicht für ein besonderes Finite-Elemente-Modell spezifisch ist, wobei das Finite-Elemente-Nachbereitungs-Framework zumindest teilweise auf einer oder mehreren Datenstrukturen basiert, die Folgendes aufweisen:
ein Verbindungsstellenelement (310) mit einer Ansammlung von Freiheitsgraden, die jeweils zwei strukturelle Komponenten verbinden,
ein Freikörperelement (330) zum Sammeln von Grenzstellen und Zusammenstellen von Lastausgleichstabellen von Komponenten, und
ein Zusammenfassungselement (340) zum Verarbeiten und Sortieren einer Auswahl von Verbindungsstellen und Erstellen einer Zusammenfassungstabelle;
eine Benutzerschnittstellenkomponente (203), die zum Empfangen von Eingaben eines Endbenutzers konfiguriert ist, wobei die Benutzerschnittstelle die Eingaben mit einer Konfigurations-Engine (205) verbindet, um das Nachbereitungs-Framework derart anzupassen, dass es auf ein spezifisches Finite-Elemente-Modell angewandt werden kann; und
eine Nachbereitungskomponente (204), die zum Durchführen einer Nachbereitung an dem spezifischen Finite-Elemente-Modell auf der Grundlage des angepassten Nachbereitungs-Frameworks konfiguriert ist.

2. System nach Anspruch 1, wobei das Anpassen des Nachbereitungs-Frameworks (200) ein Konfigurieren einer Steuerdatei zum Steuern eines oder mehrerer Prozesse, die mit dem Nachbereitungs-Framework zusammengehören, beinhaltet.

3. System nach Anspruch 1, wobei das Nachbereitungs-Framework (200) durch objektorientiertes Programmieren (206, 208, 210, 212) umgesetzt ist.

4. System nach Anspruch 1, wobei die Eingaben des Endbenutzers Folgendes beinhalten:
Verbindungsstelleninformationen (310), die für das Finite-Elemente-Modell spezifisch sind;
lokale Koordinateninformationen (320), die für das Finite-Elemente-Modell spezifisch sind;
Komponenteninformationen (330), die für das Finite-Elemente-Modell spezifisch sind; und
Voreinstellungen (340) für Zusammenfassungstabellen zur Verwendung beim Erstellen einer Zusammenfassungstabelle, die sich aus der Nachbereitung ergibt.

5. System nach Anspruch 1, wobei die Eingaben des Endbenutzers Folgendes beinhalten:
Verbindungsstelleninformationen, die für das Finite-Elemente-Modell spezifisch sind, wobei die Verbindungsstelleninformationen Knotenkoordinateninformationen (310), Elementidentifikationsinformationen (312), Zeichenkonventionsinformationen (316) und lineare Kombinationsinformationen (318) beinhalten;
lokale Koordinateninformationen (320), die für das Finite-Elemente-Modell spezifisch sind;
Komponenteninformationen (330), die für das Finite-Elemente-Modell spezifisch sind, wobei die Komponenteninformationen Markierungsinformationen (332), Bezugspunktinformationen (334) und Grenzeninformationen (336) beinhalten; und
Voreinstellungen (340) für Zusammenfassungstabellen zur Verwendung beim Erstellen einer Zusammenfassungstabelle, die sich aus der Nachbereitung ergibt, wobei die Informationen der Zusammenfassungstabelle Kopfzeileninformationen (342), Fußnoteninformationen (344) und Freiheitsgradinformationen (346) beinhalten.

6. System nach Anspruch 1, wobei das Finite-Elemente-Nachbereitungs-Framework (200) zumindest teilweise auf einer oder mehreren Datenstrukturen basiert, die Folgendes aufweisen:
ein Datenbankelement (402);
ein Nutzenfunktionselement (410);
ein Sendeelement (412), das gemäß einem Gesamtprozessablauf und Umfang der Nachbereitung instanziiert wird; und
ein grafisches Benutzerschnittstellenelement (414).

7. System nach Anspruch 1, wobei der Endbenutzer kein festes Programmieren beim Bereitstellen von Eingaben an die Schnittstelle durchführt.

8. System nach Anspruch 1,
wobei die Eingaben des Endbenutzers Folgendes beinhalten:
Verbindungsstelleninformationen, die für das Finite-Elemente-Modell spezifisch sind,
lokale Koordinateninformationen, die für das Finite-Elemente-Modell spezifisch sind,
Komponenteninformationen, die für das Finite-Elemente-Modell spezifisch sind, und
Voreinstellungen für Zusammenfassungstabellen zur Verwendung beim Erstellen einer Zusammenfassungstabelle, die sich aus der Nachbereitung ergibt; und
wobei das Finite-Elemente-Nachbereitungs-Framework zumindest teilweise auf einer oder mehreren Datenstrukturen basiert, die Folgendes aufweisen:
ein Datenbankelement (402),
ein Verbindungsstellenelement (404) mit einer Ansammlung von Freiheitsgraden, die jeweils zwei strukturelle Komponenten verbinden,
ein Freikörperelement (406) zum Sammeln von Grenzverbindungsstellen und Zusammenstellen von Lastausgleichstabellen von Komponenten,
ein Zusammenfassungselement (408) zum Verarbeiten und Sortieren einer Auswahl von Verbindungsstellen und Erstellen einer Zusammenfassungstabelle,
ein Nutzenfunktionselement (410),
ein Sendeelement (412), das gemäß einem Gesamtprozessablauf und Umfang der Nachbereitung instanziiert wird, und
ein grafisches Benutzerschnittstellenelement (414).

9. Verfahren zum Durchführen einer Verarbeitung eines Finite-Elemente-Modells, wobei das Verfahren aufweist:
Empfangen von Eingaben zur Verwendung beim Erstellen einer oder mehrerer Steueranweisungen zum Definieren einer angepassten Verarbeitungsroutine, die auf ein spezifisches Finite-Elemente-Modell angewandt werden kann, wobei das Empfangen der Eingaben kein Schreiben oder Umschreiben von Programmiercode in einer Programmiersprache durch einen Benutzer beinhaltet; und
Erstellen der einen oder mehreren Steueranweisungen auf der Grundlage der empfangenen Eingaben, einschließlich Anwenden der empfangenen Eingaben auf ein allgemeines Verarbeitungs-Framework, wobei das Erstellen der Steueranweisungen kein Schreiben oder Umschreiben von Programmiercode durch einen Benutzer beinhaltet und wobei das Erstellen der einen oder mehreren Steueranweisungen durch eine Nachbereitungs-Softwareeinrichtung ausgeführt wird, die zumindest teilweise auf der Grundlage einer oder mehrerer Software-Programmierklassen definiert ist, die zumindest eine der folgenden beinhalten:
eine Verbindungsstellenklasse (404) mit einer Ansammlung von Freiheitsgraden, die jeweils zwei strukturelle Komponenten verbinden,
eine Freikörperklasse (406) zum Sammeln von Grenzverbindungsstellen und Zusammenstellen von Lastausgleichstabellen von Komponenten, definiert auf der Grundlage der Eingaben des Endbenutzers, und
eine Zusammenfassungsklasse (408) zum Verarbeiten und Sortieren einer Auswahl von Verbindungsstellen und Erstellen einer Zusammenfassungstabelle.

10. Verfahren nach Anspruch 9, weiter aufweisend Durchführen einer Nachbereitung an einem oder mehreren Finite-Elemente-Modellen auf der Grundlage der einen oder mehreren Steueranweisungen.

11. Verfahren nach Anspruch 9, weiter aufweisend Durchführen einer Nachbereitung an einem oder mehreren Finite-Elemente-Modellen auf der Grundlage der einen oder mehreren Steueranweisungen, wobei die Nachbereitung Folgendes beinhaltet:
Definieren einer Konfiguration (206) für die Nachbereitung, basierend zumindest teilweise auf der einen oder den mehreren Steueranweisungen;
Verarbeiten von Verbindungsstellenlasten (208), basierend zumindest teilweise auf der einen oder den mehreren Steueranweisungen;
Verarbeiten von Lastausgleich (210), basierend zumindest teilweise auf der einen oder den mehreren Steueranweisungen; und
Verarbeiten von Zusammenfassungstabellen (212), basierend zumindest teilweise auf der einen oder den mehreren Steueranweisungen.

12. Verfahren nach Anspruch 9, wobei die empfangenen Eingaben in einer oder mehreren Datenstrukturen (310, 320, 330, 340) gesammelt werden, die auf einem computerlesbaren Medium gespeichert sind, wobei jede der einen oder mehreren Datenstrukturen einen oder mehrere Typen von Informationen aus einer Gruppe beinhaltet, die Folgendes aufweist:
Verbindungsstelleninformationen, die für das Finite-Elemente-Modell spezifisch sind;
lokale Koordinateninformationen, die für das Finite-Elemente-Modell spezifisch sind;
Komponenteninformationen, die für das Finite-Elemente-Modell spezifisch sind; und
Voreinstellungen für Zusammenfassungstabellen, die für das Finite-Elemente-Modell spezifisch sind.

13. Verfahren nach Anspruch 9, wobei das allgemeine Verarbeitungs-Framework ein objektorientiertes Nachbereitungs-Framework ist.

14. Verfahren nach Anspruch 9, wobei das Verarbeitungs-Framework mit einem Nachbereitungsaspekt einer Anwendung zur Finite-Elemente-Analyse zusammengehört.

15. Verfahren nach Anspruch 9, wobei die Eingaben über eine Endbenutzer-Schnittstelle empfangen werden und Daten beinhalten, aber keine expliziten Beziehungen zwischen Daten.

16. Verfahren nach Anspruch 9, wobei das Erstellen der Steueranweisungen zumindest teilweise durch eine Steuerkomponenten-Engine (205) durchgeführt wird.

## Revendications

1. Système de modèles d'analyse par éléments finis, le système comprenant :
une structure de post-traitement par éléments finis (200), la structure de post-traitement par éléments finis n'était pas spécifique à un modèle par éléments finis particulier, la structure de post-traitement par éléments finis étant basée au moins en partie sur au moins une structure de données comprenant :
un élément d'interface (310) incluant une collection de degrés de liberté, chacun connectant deux éléments structuraux,
un élément de corps libre (300) pour collecter des interfaces limites et assembler des tableaux de répartition de charge de composants,
un élément récapitulatif (340) pour traiter et trier une sélection d'interfaces et générer un tableau récapitulatif ;
un composant d'interface d'utilisateur (203) conçu pour recevoir des entrées depuis un utilisateur final, l'interface d'utilisateur couplant lesdites entrées à un moteur de configuration (205) pour personnaliser la structure de post-traitement de façon qu'on puisse l'appliquer à un modèle par éléments finis ; et
un composant post-traitement (204) conçu pour effectuer un post-traitement sur le modèle par éléments finis spécifique sur la base de la structure de post-traitement personnalisée.

2. Système selon la revendication 1, dans lequel la personnalisation de la structure de post-traitement (200) inclut la configuration d'un fichier de contrôle afin de contrôler un ou plusieurs procédés associés à la structure de post-traitement.

3. Système selon la revendication 1, dans lequel la structure de post-traitement (200) est mise en oeuvre en utilisant une programmation orientée objet (206, 208, 210, 212).

4. Système selon la revendication 1, dans lequel les entrées de l'utilisateur final incluent :
des informations d'interface (310) spécifiques au modèles par éléments finis ;
des informations de coordonnées locales (320) spécifiques au modèles par éléments finis ;
des informations de composant (330) spécifiques au modèles par éléments finis ; et
des préférences de tableau récapitulatif (340) destinées à être utilisées pour générer un tableau récapitulatif résultant du post-traitement.

5. Système selon la revendication 1, dans lequel les entrées de l'utilisateur final incluent :
des informations d'interface spécifiques au modèles par éléments finis, les informations d'interface incluant des informations de coordonnées nodales (310), des informations d'identifiant d'élément (312), des informations de convention de signe (316) et des informations de combinaison linéaire (318) ;
des informations de coordonnées locales (320) spécifiques au modèle par éléments finis ;
des informations de composant (330) spécifiques au modèle par éléments finis, les informations de composant incluant des informations d'étiquetage (332), des informations de point de référence (334) et des informations de limite (336) ; et
des préférences de tableau récapitulatif (340) destinées à être utilisées pour générer un tableau récapitulatif résultant du post-traitement, les informations du tableau récapitulatif incluant des informations d'entête (342), des informations de note de bas de page (344) et des informations de degrés de liberté (346).

6. Système selon la revendication 1, dans lequel la structure de post-traitement par éléments finis (200) est basée au moins en partie sur au moins une structure de données comprenant :
un élément base de données (402) ;
un élément fonctions utilitaires (410) ;
un post-élément (412) illustré selon le flux de procédé global et l'étendue du post-procédé ; et
un élément interface graphique d'utilisateur (414).

7. Système selon la revendication 1, dans lequel l'utilisateur final n'effectue pas de codage en dur quand il fournit des entrées à l'interface.

8. Système selon la revendication 1, dans lequel les entrées de l'utilisateur final incluent :
des informations d'interface spécifiques au modèle par éléments finis,
des informations de coordonnées locales spécifiques au modèle par éléments finis,
des informations de composant spécifiques au modèle par éléments finis, et
des préférences de tableau récapitulatif destinées à être utilisées pour générer un tableau récapitulatif résultant du post-traitement ; et
dans lequel la structure de post-traitement par éléments finis est basée, au moins en partie, sur au moins une structure de données comprenant :
un élément base de données (402) ;
un élément d'interface (404) incluant une collection de degrés de liberté, chacun connectant deux éléments structuraux,
un élément de corps libre (406) pour collecter des interfaces limites et assembler des tableaux de répartition de charge de composants,
un élément récapitulatif (408) pour traiter et trier une sélection d'interfaces et générer un tableau récapitulatif ;
un élément fonctions utilitaires (410) ;
un post-élément (412) illustré selon le flux de procédé global et l'étendue du post-procédé ; et
un élément interface graphique d'utilisateur (414).

9. Procédé pour mener un traitement d'un modèle par éléments finis, le procédé comprenant :
la réception d'entrées destinées à générer au moins une instruction de contrôle pour définir une routine de traitement personnalisé qui peut s'appliquer à un modèle spécifique par éléments finis, la réception des entrées n'incluant pas une écriture ni une réécriture par l'utilisateur d'un code de programme dans un langage de programmation ; et
la génération d'au moins une instruction de contrôle sur la base des entrées reçues, y compris l'application des entrées reçues à une structure de traitement générique, la génération des instructions de contrôle n'incluant pas d'écriture ni de réécriture de code de programmation, et la génération de l'au moins une instruction de contrôle étant exécutée par un logiciel post-traitement défini, au moins en partie, en fonction d'au moins une classe de programmation de logiciel incluant au moins un parmi :
une classe d'interface (404) incluant une collection de degrés de liberté, chacun connectant deux éléments structuraux,
une classe de corps libre (406) pour collecter des interfaces limites et assembler des tableaux de répartition de charge de composants en fonction des entrées de l'utilisateur final, et
un élément récapitulatif (408) pour traiter et trier une sélection d'interfaces et générer un tableau récapitulatif.

10. Procédé selon la revendication 9, comprenant en outre d'effectuer un post-traitement sur au moins un modèle par éléments finis sur l'au moins une instruction de contrôle.

11. Procédé selon la revendication 9, comprenant en outre d'effectuer un post-traitement sur au moins un modèle par éléments finis sur l'au moins une instruction de contrôle, le post-traitement incluant :
la définition d'une configuration (206) pour le post-traitement sur la base, au moins en partie, de l'au moins une instruction de contrôle ;
le traitement des charges d'interface (208) sur la base, au moins en partie, de l'au moins une instruction de contrôle ;
le traitement de répartitions de charge (210) sur la base, au moins en partie, de l'au moins une instruction de contrôle ; et
le traitement de tableaux récapitulatifs (212) sur la base, au moins en partie, de l'au moins une instruction de contrôle.

12. Procédé selon la revendication 9, dans lequel les entrées reçues sont collectées dans au moins une structure de données (310, 320, 330, 340) stockée sur un médium lisible par un ordinateur, chacune des au moins une structure de données incluant au moins un type d'informations du groupe comprenant :
des informations d'interface spécifiques du modèle par éléments finis ;
des informations de coordonnées locales spécifiques du modèle par éléments finis ;
des informations de composants spécifiques du modèle par éléments finis ; et
des préférences de tableau récapitulatif spécifiques du modèle par éléments finis.

13. Procédé selon la revendication 9, dans lequel la structure de traitement générique est une structure post-traitement orientée objet.

14. Procédé selon la revendication 9, dans lequel la structure de traitement est associée à un aspect post-traitement d'une application d'analyse par éléments finis.

15. Procédé selon la revendication 9, dans lequel les entrées sont reçues via une interface d'utilisateur final et incluent de données mais pas de relations explicites entre les données.

16. Procédé selon la revendication 9, dans lequel la génération des instructions de contrôle est effectuée, au moins en partie, par un moteur de composant de contrôle (205).
